# FASCICULE DE BREVET EUROPEEN

(11) **EP 0 401 136 B1**
(45) Date de publication et mention de la délivrance du brevet: **17.07.1996**
(21) Numéro de dépôt: 90420259.5
(22) Date de dépôt: 30.05.1990
(51) Int. Cl.: H03K 17/14, H03K 17/95, H03L 1/02

(54) **Procédé et dispositif de détection compensé en température de l'oscillation d'un circuit résonant**
Detektionsverfahren und Einrichtung zum Temperaturkompensieren der Schwingung einer Resonanzschaltung
Detection circuit and method for temperature-compensating of the oscillation of a resonating circuit

(30) Priorité: 02.06.1989 FR 8907820
(43) Date de publication de la demande: 05.12.1990
(73) Titulaire: SGS-THOMSON MICROELECTRONICS SA, F-94250 Gentilly (FR)
(72) Inventeur: Moreau, Jean-Michel, F-38100 Grenoble (FR)
(74) Mandataire: de Beaumont, Michel

(56) Documents cités:
- EP-A- 0 070 796
- EP-A- 0 319 470
- DE-A- 3 322 701
- DE-A- 3 513 403
- US-A- 3 328 680
- PATENT ABSTRACTS OF JAPAN, vol. 11, no. 223 (P-597)[2670], 21 juillet 1987; & JP-A-62 038 382 (NIPPON KOKAN K.K.) 19-02-1987

## Description

La présente invention concerne le domaine des détecteurs de distance et capteurs de proximité.

De façon classique, une capteur de proximité comprend un circuit oscillant à bobine et condensateur dont le facteur de surtension dépend de la distance entre la bobine et une pièce métallique en déplacement constituée par l'objet dont on veut détecter la distance à la bobine ou une pièce métallique liée au déplacement de cet objet. Différents dispositifs sont prévus pour mesurer la variation du facteur de surtension, en détectant la variation d'amplitude des oscillations ou bien en provoquant le décrochement de ces oscillations quand une distance critique est atteinte.

Comme cela est exposé de façon très détaillée dans la demande de brevet européen EP-A-0070796, ces détecteurs de proximité sont très sensibles aux variations de température ce qui réduit considérablement leur capacité de détection si aucune mesure n'est prise pour réaliser la compensation de température.

Ainsi, ce document EP-A-0070796 propose un procédé permettant de rendre constante l'amplitude des oscillations du circuit résonant quelle que soit la variation de température.

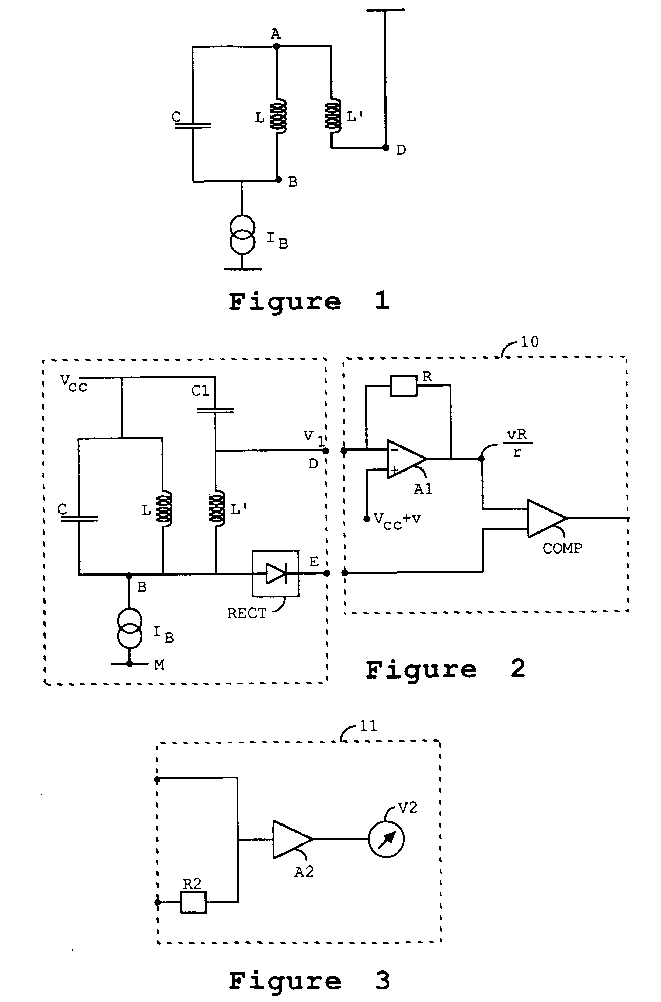

Ce procédé va être rappelé en relation avec la figure 1. Il consiste à utiliser une source de courant alternatif à la fréquence de résonance et d'amplitude constante IB. Ce courant circuit de la borne B à la borne A d'un circuit résonant constitué par un enroulement L et un condensateur C et se referme en passant par un enroulement L′ dont la deuxième borne est connectée à une point D. Les inductances L et L′ sont en fait constituées de fils divisés et isolés entre eux d'une même bobine. Ainsi, pour la circulation de courant entre les bornes B et D passant par les inductances L et L′, celles-ci peuvent être considérées comme des résistances pures, les effets selfiques se compensant en raison du couplage élevé entre elles. Quand il se produit une variation de température, la résistance de l'enroulement L augmente, le facteur de surtension Q du circuit oscillant a donc tendance à diminuer, c'est-à-dire que l'amplitude des oscillations a tendance à diminuer. Mais simultanément la différence de potentiel aux bornes de L, c'est-à-dire aux bornes du circuit oscillant, a tendance à augmenter puisqu'elle est égale à la résistance de L multipliée par le courant IB et que cette résistance a augmenté. En conséquence, la diminution du coefficient de surtension est compensée par l'augmentation de la tension aux bornes et l'amplitude des oscillations du circuit résonant reste sensiblement constante quand la température varie. On a donc bien obtenu un circuit résonant fournissant des oscillations d'amplitude sensiblement constante indépendamment des variations de température.

Toutefois, un problème se pose quand on veut utiliser un tel circuit comme capteur de proximité et encore plus comme détecteur de distance. En effet, la résistance que l'on a considérée jusqu'ici comme étant la résistance de l'inductance L est en fait la résistance parallèle équivalente du circuit résonant à la fréquence d'oscillation. Cette résistance équivalente dépend du facteur de couplage de la bobine avec une masse métallique dont on veut détecter le déplacement. Ainsi, le circuit décrit précédemment tend à fournir des oscillations d'amplitude constante non seulement quand la température varie mais également quand le facteur de couplage susmentionné varie. Il sera donc peu sensible comme détecteur de proximité puisqu'il tend à compenser le phénomène que l'on cherche à détecter. Il ne permet en tout cas pas de fournir à tout instant une indication des variations de distance entre une pièce métallique et la bobine.

Ainsi, un objet de la présente invention est de prévoir un détecteur de distance, également utilisable en capteur de proximité, permettant de s'affranchir des effets de variations de température.

Pour atteindre cet objet, alors que le procédé du document susmentionné prévoyait de compenser l'amplitude d'oscillation en tenant compte des variations en courant alternatif de la résistance des spires de la bobine, la présente invention prévoit d'effectuer une détection en courant continu de la résistance des spires, cette détection en courant continu dépend alors seulement des effets de température et non plus du facteur de couplage et d'utiliser cette information pour corriger un signal de détection correspondant à la tension de sortie du circuit oscillant dont l'amplitude d'oscillation n'est pas stabilisée en température.

Ces objets, caractéristiques et avantages ainsi que d'autres de la présente invention seront exposés plus en détail dans la description suivante de modes de réalisation particuliers de la présente invention faite en relation avec les figures jointes parmi lesquelles :
la figure 1, destinée à exposer l'état de la technique, a été décrite précédemment ;
la figure 2 représente schématiquement un circuit selon la présente invention dans son application à un capteur de proximité ; et
la figure 3 illustre une variante du circuit selon la présente invention constituant un détecteur de distance.

Comme le représente la figure 2, un circuit selon la présente invention comprend une source de courant alternatif d'amplitude constante IB connectée entre un premier potentiel constant M et un deuxième potentiel constant VCC, ce courant traversant un circuit oscillant comprenant un condensateur C et une inductance L correspondant à la bobine du capteur de proximité. Cette bobine est constituée de fils divisés isolés entre eux pour former en plus de l'inductance L une inductance L′ reliée à l'inductance L à son point de connexion B avec la source de courant. L'autre borne de l'inductance L′ est reliée à un potentiel flottant V1 par une borne D. Ainsi, un courant continu circule entre le potentiel VCC et le potentiel V1 en passant par les enroulements en série L et L′. En raison du très fort couplage entre les deux enroulements, pratiquement aucun courant alternatif ne circule entre les potentiels VCC et V1 en passant par les enroulements série L et L′. Pour éviter l'apparition de toute tension alternative parasite, on pourra relier les extrémités des enroulements L et L′ entre elles par un condensateur optionnel C1 de valeur adaptée. Ce condensateur C1 permet en outre de mettre en parallèle, pour l'alternatif, l'enroulement L′ avec l'enroulement L et donc de ne pas dégrader le facteur de qualité.

D'autre part, le signal à la borne B du circuit oscillant est détecté par un redresseur RECT et est disponible sur une borne E.

Comme on l'a exposé précédemment, la variation de la résistance en courant continu dans les enroulements L et L′ peut être utilisée selon l'invention pour compenser les fluctuations du signal sur la borne E avec la température.

Le bloc 10 représente une exemple de circuit assurant cette fonction dans le cadre d'un capteur de proximité, c'est-à-dire d'un circuit indiquant si un objet à détecter se trouve en deçà ou au-delà d'une distance prédéterminée par rapport à la bobine. Le circuit 10 comprend un amplificateur opérationnel A1 dont l'entrée non-inverseuse est reliée à un potentiel de référence VCC + v et dont la sortie est reliée à l'entrée inverseuse par une résistance R de valeur élevée. Cette entrée inverseuse est également reliée à la borne D de l'enroulement L′. Ainsi, il existe entre l'entrée inverseuse et la tension VCC une résistance r correspondant à la somme des résistances en courant continu des enroulements L et L′. L'amplificateur A1 fournit en sortie une tension égale à v(1+R/r) soit environ vR/r dans le cas où l'on choisit R nettement supérieur à r. La tension de sortie varie donc comme l'inverse de la résistance (en continu) de la bobine.

Par ailleurs, la tension du circuit oscillant est quant à elle proportionnelle au facteur de surtension de ce circuit oscillant que l'on peut exprimer par l'expression Q = 2πfL/R_{Cu}, f étant la fréquence d'accord, L l'inductance de la bobine et R_{Cu} la résistance en courant alternatif de la bobine à la fréquence d'accord. Le signal sur la borne E est proportionnel à cette valeur et est envoyé sur une première borne d'un comparateur COMP dont la deuxième borne reçoit la sortie de l'amplificateur opérationnel A1.

Si la température varie, la valeur de R_{Cu} et l'amplitude des oscillations varient ; de même la valeur de r et donc la tension de référence vR/r à la deuxième entrée du comparateur COMP varient dans le même sens. Il est donc clair qu'en choisissant convenablement les valeurs de v et de R on peut assurer une correction en température adéquate.

Si le facteur de couplage, c'est-à-dire la distance entre l'objet à détecter et la bobine, varie, l'amplitude des oscillations du circuit oscillant varie et la tension redressée sur la borne E varie de façon correspondante mais, par contre, la valeur de r qui correspond à une détection en courant continu des résistances des enroulements L et L′ ne varie pas. Il est donc possible de faire une détection simple à la sortie du comparateur COMP et d'effectuer un réglage de la distance de déclenchement en faisant varier la tension v, la résistance R, ou le courant IB en fonction de la distance choisie.

En raison de cette possibilité d'obtention selon la présente invention d'un signal de référence dépendant uniquement de la température et non pas des autres facteurs de variation du facteur de qualité d'une bobine détectrice, il est possible d'appliquer la présente invention non seulement à un capteur de proximité fournissant une réponse binaire mais encore à un détecteur de distance fournissant une indication pratiquement linéaire de la distance entre une bobine et une masse métallique.

Pour ce faire, on pourra remplacer en figure 2 le bloc 10 par le bloc 11 de la figure 3. Le bloc 11 comprend une résistance R2 connectée à l'entrée d'un amplificateur A2 dont la sortie est reliée à un moyen de mesure tel qu'un voltmètre analogique V2. L'entrée de l'amplificateur A2 est également reliée à la borne D de la figure 2. Dans ce montage, si l'on considère le trajet du courant continu, la tension sur la borne E est appliquée à un potentiomètre comprenant sur un bras la résistance R2 et sur l'autre bras la somme r des résistances des enroulements L et L' reliés à la tension VCC. Comme la résistance r varie avec la température en même temps que la tension VE (VE étant référencée à VCC) sur la borne E, cette variation de température peut être parfaitement compensée et le voltmètre V2 fournit une indication indépendante de la température. Cette indication est caractéristique de la variation de l'impédance équivalente du circuit oscillant en fonction du facteur de couplage. Comme cela est connu de l'homme de l'art, cette indication est sensiblement linéaire au moins dans une plage de fonctionnement. Le volmètre V2 peut donc être gradué directement en distances de cible.

Pour obtenir une bonne compensation en température, il conviendra de choisir R2 » r puisque la tension aux bornes de r est égale à VE[r/(r+R2)] et qu'elle devient alors sensiblement égale à VE[r/R2] (proportionelle à r).

L'homme de l'art pourra imaginer d'autres applications du procédé de compensation en température du signal de sortie d'un circuit résonant. En particulier, dans les modes de réalisation décrits de la présente invention, le signal de compensation correspondant à la résistance en courant continu d'une bobine d'un cicuit résonant est utilisé en relation avec le signal de sortie redressé du circuit résonant.

Il sera en outre possible d'adjoindre au circuit de la présente invention les perfectionnements usuellement apportés aux capteurs de proximité.

## Revendications

1. Procédé de compensation de la dépendance en température du signal de sortie fourni par un circuit résonant excité par un générateur produisant un courant alternatif d'amplitude constante, à la fréquence de résonance du circuit oscillant, caractérisé en ce qu'il consiste à :
produire un signal de correction en utilisant la variation en fonction de la température de la résistance spécifique pour un courant continu du matériau conducteur de la bobine oscillatrice, ledit signal de correction étant dérivé d'un courant continu traversant la bobine oscillatrice,
redresser ledit signal de sortie, et
combiner ledit signal de revendication et ledit signal de sortie redressé pour fournir un signal de sortie compensé en température.

2. Détecteur de distance compensé en température comprenant un circuit mettant excité par en générateur produisant un courant alternatif d'amplitude constante à la fréquence de résonance du circuit oscillant, dans lequel la bobine est réalisée sous forme de fils divisés isolés entre eux, caractérisé en ce ce qu'un premier ensemble de fils (L) constitue la bobine oscillatrice connectée en parallèle avec un condensateur et alimentée entre deux potentiels distincts (VCC et M) par ledit générateur (IB) produisant un courant alternatif d'amplitude constante et en ce qu'un deuxième ensemble de fils (L'), connecté par une première extrémité au premier ensemble de fils et au générateur, est relié par son autre extrémité à un troisième potentiel (V1), d'où il résulte qu'un courant continu traverse la connexion en série des premier et deuxième ensembles de fils et fournit un signal de correction, en ce qu'un redresseur (RECT) redresse le signal du circuit résonant, et en ce qu'il comprend des moyens (A1, R1, COMP ; R2, A2) pour combiner le signal redressé et le signal de correction pour fournir un signal de distance indépendant de la température.

3. Détecteur de distance selon la revendication 2, caractérisé en ce que la tension redressée aux bornes du circuit résonant est fournie à une première borne d'un comparateur (COMP) dont l'autre borne reçoit une tension de référence (vR/r) inversement proportionnelle à la résistance en courant continu des bobines, cette tension étant fournie par un amplificateur opérationnel (A1) dont l'entrée non-inverseuse est reliée à ladite autre extrémité (D) du deuxième ensemble de fils (L') et à sa sortie par une résistance de valeur élevée (R).

4. Détecteur de distance selon la revendication 2, caractérisé en ce que la tension redressée aux bornes du circuit résonant est appliquée à l'entrée d'un amplificateur (A2) dont la sortie est fournie à un dispositif de mesure (V2), l'entrée de l'amplificateur étant également reliée à ladite autre extrémité (D) du deuxième ensemble de fils (L').

## Patentansprüche

1. Verfahren zum Kompensieren der Temperaturabhängigkeit des von einer Resonanz schaltung gelieferten Ausgangssignals, die durch einen Generator erregt wird, der einen Wechselstrom mit einer konstanten Amplitude bei der Resonanzfrequenz der Oszillatorschaltung liefert, gekennzeichnet durch:
Erzeugen eines Korrektursignals unter Verwendung der Änderung des spezifischen Widerstandes des leitenden Materials der Oszillatorspule bei einem Gleichstrom, und zwar als einer Funktion der Temperatur, wobei das Korrektursignal von einem durch die Oszillatorspule fließenden Gleichstrom abgeleitet wird,
Gleichrichten des Ausgangssignals, und
Kombinieren des Korrektursignals und das gleichgerichteten Ausgangssignals zum Vorsehen eines temperaturkompensierten Ausgangssignals.

2. Temperaturkompensierter Abstandsdetektor, der folgendes aufweist: eine Resonanzschaltung, die durch einen Generator erregt wird, der einen Wechselstrom mit einer konstanten Amplitude bei der Resonanzfrequenz der Oszillatorschaltung erzeugt, bei der die Spule in der Form von Drähten realisiert wird, die voneinander getrennt und isoliert sind, dadurch gekennzeichnet, daß ein erster Satz von Drähten (L) die Oszillatorspule bildet, die mit einem Kondensator parallel geschaltet ist und zwischen zwei bestimmten bzw. getrennten Potentialen (VCC und M) durch den Generator (IB) gespeist wird, der einen Wechselstrom mit konstanter Amplitude erzeugt,
daß ein zweiter Satz von Drähten (L'), der an einem ersten Ende mit dem ersten Satz von Drähten und dem Generator verbunden ist, an seinem anderen Ende mit einem dritten Potential (V1) verbunden ist, wodurch ein Gleichstrom durch die Serienschaltung der ersten und zweiten Sätze von Drähten strömt,
daß ein Gleichrichter (RECT) das Signal der Resonanzschaltung gleichrichtet, und
daß er Mittel (A1,R1,COMP;R2,A2) aufweist zum Kombinieren des gleichgerichteten Signals und des Korrektursignals zum Vorsehen eines temperaturunabhängigen Abstandssignals.

3. Abstandsdetektor gemäß Anspruch 2, dadurch gekennzeichnet, daß die gleichgerichtete Spannung an den Anschlüssen der Resonanz schaltung an einen ersten Anschluß eines Komparators (COMP) geliefert wird, wobei der andere Anschluß davon eine Bezugspannung (vR/r) empfängt, die umgekehrt proportional zu dem Gleichstromwiderstand der Spulen ist, wobei diese Spannung durch einen Operationsverstärker (A1) geliefert wird, dessen nichtinvertierender Eingang mit dem anderen Ende (D) des zweiten Satzes von Drähten (L') und durch einen Widerstand (R) mit hohem Wert mit seinem Ausgang verbunden ist.

4. Abstandsdetektor nach Anspruch 2, dadurch gekennzeichnet, daß die gleichgerichtete Spannung an der Resonanzschaltung an den Eingang eines Verstärkers (A2) angelegt wird, dessen Ausgang bzw. Ausgangsgröße an eine Meßeinrichtung (V2) geliefert wird, wobei der Eingang des Verstärkers auch mit dem anderen Ende (D) des zweiten Satzes von Drähten (L') verbunden ist.

## Claims

1. A method for compensating the temperature dependence of the output signal supplied by a resonant circuit driven by a generator producing an a.c. current having a constant amplitude at the resonance frequency of the oscillating circuit, characterized in that it consists of
producing a correction signal by using the variation as a function of the temperature of the specific resistance for a d.c. current of the conductive material of the oscillating coil, said correction signal being derived from a d.c. current flowing through the oscillating coil,
rectifying said output signal, and
combining said correction signal and said rectified output signal to provide a temperature-compensated output signal.

2. A temperature-compensated distance detector comprising a resonant circuit driven by a generator producing an a.c. current having a constant amplitude at the resonance frequency of the oscillating circuit, in which the coil is realized in the form of wires, divided and isolated one from the other, characterized in that a first set of wires (L) constitutes the oscillating coil parallel connected to a capacitor and fed between two distinct potentials (VCC and M) by said generator (IB) producing an a.c. current of constant amplitude, in that a second set of wires (L'), connected at a first extremity to the first set of wires and to the generator, is connected at its other extremity to a third potential (V1), whereby a d.c. current flows through the series connection of the first and second sets of wires, in that a rectifier (RECT) rectifies the signal of the resonant circuit, and in that it comprises means (A1, R1, COMP; R2, A2) for combining the rectified signal and the correction signal to provide a temperature-independent distance signal.

3. A distance detector according to claim 2, characterized in that the rectified voltage across the terminals of the resonant circuit is supplied to a first terminal of a comparator (COMP), the other terminal of which receives a reference voltage (vR/r) inversely proportional to the d.c. resistance of the coils, said voltage being supplied by an operational amplifier (A1), the non-inverting input of which is connected to said other extremity (D) of the second set of wires (L') and to its output through a high value resistor (R).

4. A distance detector according to claim 2, characterized in that the rectified voltage across the resonant circuit is applied to the input of an amplifier (A2), the output of which is supplied to a measurement device (V2), the input of the amplifier being also connected to said other extremity (D) of the second set of wires (L').
